# EUROPEAN PATENT APPLICATION

(11) **EP 4 443 505 A1**
(43) Date of publication of application: **09.10.2024**
(21) Application number: 24168305.1
(22) Date of filing: 03.04.2024
(51) Int. Cl.: H01L 25/075, H01L 33/20, H01L 33/62

(54) **MICRO LED PIXEL AND MICRO LED PANEL**

(30) Priority: 07.04.2023 WO PCT/CN2023/086882
(71) Applicant: Jade Bird Display (Shanghai) Limited, Shanghai 200120 (CN)
(72) Inventor: XU, Qunchao, Shanghai, 200120 (CN); TAN, WeiSin, Shanghai, 200120 (CN)
(74) Representative: Finnegan Europe LLP

(57) **Abstract**

A micro LED pixel and a micro LED panel are provided. The micro LED pixel includes a first light emitting mesa; a second light emitting mesa provided above the first light emitting mesa and covering a part of the first light emitting mesa; and a third light emitting mesa provided above the second light emitting mesa and covering a part of the second light emitting mesa; wherein a shape of a top surface of the first light emitting mesa is a triangle.

## Description

### CROSS-REFERENCE TO RELATED APPLICATIONS

The present disclosure claims priority to and the benefits of PCT Application No. PCT/CN2023/086882, filed on April 7, 2023, which is incorporated herein by reference in its entirety.

### TECHNICAL FIELD

The present disclosure generally relates to micro display technology, and more particularly, to a micro light emitting diode (LED) and a micro LED panel.

### BACKGROUND

Generally, a traditional micro LED pixel includes three or more micro LED mesas disposed side by side to form a micro LED panel. The three or more micro LEDs mesas may emit different color light. However, it does not serve to decrease dimensions of the micro LED pixel.

To reduce a volume of a micro LED pixel, the micro LED pixel may include several micro LED layers formed vertically with a same asymmetric axis. The micro LED layers define a light emitting area, and electrodes of the micro LED layers are formed on an external panel outside the light emitting area of the micro LED pixel. However, the external panel may increase the dimensions of a micro LED pixel.

Therefore, the micro LED pixel structure needs to be further improved to reduce the dimensions and increase the light emitting area of a micro LED pixel.

### SUMMARY OF THE DISCLOSURE

Embodiments of the present disclosure provide a micro LED pixel. The micro LED pixel includes: a first light emitting mesa; a second light emitting mesa provided above the first light emitting mesa and covering a part of the first light emitting mesa; and a third light emitting mesa provided above the second light emitting mesa and covering a part of the second light emitting mesa; wherein a shape of a top surface of the first light emitting mesa is a triangle.

Embodiments of the present disclosure provide a micro LED panel. The micro LED panel includes two or more described-above micro LED pixels.

### BRIEF DESCRIPTION OF THE DRAWINGS

Embodiments and various aspects of the present disclosure are illustrated in the following detailed description and the accompanying figures. Various features shown in the figures are not drawn to scale.
**FIG. 1** illustrates a structural diagram showing a top view of a micro LED pixel, according to some embodiments of the present disclosure.
**FIG. 2** illustrates a structural diagram showing a sectional view of the micro LED pixel along a section line A-A' shown in **FIG. 1** ,according to some embodiments of the present disclosure.
**FIG. 3** illustrates a structural diagram showing a sectional view of the micro LED pixel along a section line B-B' shown in **FIG. 1** ,according to some embodiments of the present disclosure.
**FIG. 4** illustrates a structural diagram showing a top view of an example micro LED panel, according to some embodiments of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims. Particular aspects of the present disclosure are described in greater detail below. The terms and definitions provided herein control, if in conflict with terms and/or definitions incorporated by reference.

To reduce the dimensions and increase the light emitting area of a micro LED pixel, embodiments of the present disclosure provide an improved micro LED pixel.

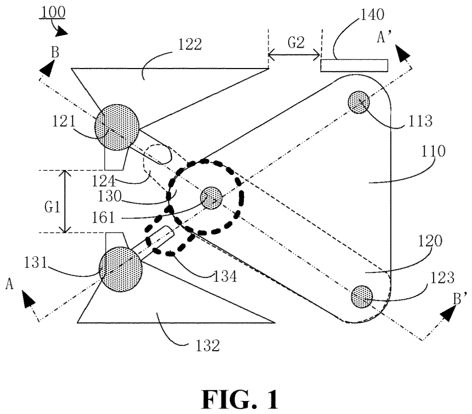

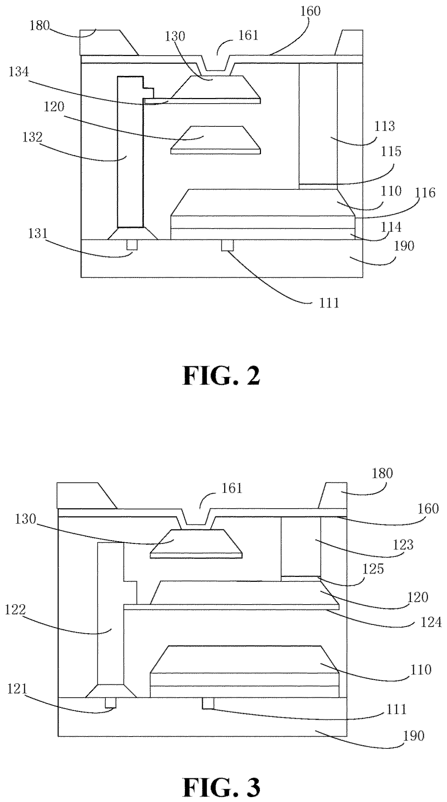

**FIG. 1** illustrates a structural diagram showing a top view of a micro LED pixel 100, according to some embodiments of the present disclosure. **FIG. 2** illustrates a structural diagram showing a sectional view of the micro LED pixel along a section line A-A' shown in **FIG. 1,** according to some embodiments of the present disclosure. **FIG. 3** illustrates a structural diagram showing a sectional view of the micro LED pixel along a section line B-B' shown in **FIG. 1** ,according to some embodiments of the present disclosure.

Referring to **FIGs. 1** to **3,** micro LED pixel 100 includes three or more light emitting mesas, for example, a first light emitting mesa 110, a second light emitting mesa 120, and a third light emitting mesa 130. In a vertical direction, as viewed in **FIGs. 2** and **3****,** first light emitting mesa 110, second light emitting mesa 120 and third light emitting mesa 130 are provided at different positions from bottom to top. For example, first light emitting mesa 110 is provided lower than second light emitting mesa 120, and second light emitting mesa 120 is provided lower than third light emitting mesa 130. In some embodiments, each of the light emitting mesas 110, 120, 130 has a columnar structure. That is, a shape of a top surface of the light emitting mesa and a shape of a bottom surface of the light emitting mesa are the same. In some embodiments, an area of the top surface of the light emitting mesa is smaller than an area of the bottom surface of the light emitting mesa.

Micro LED pixel 100 further includes an integrated circuit (IC) backplane 190 provided as a base of micro LED pixel 100. The three or more light emitting mesas are provided above IC backplane 190. Each light emitting mesa is connected to a top electrode and a bottom electrode respectively. A First bottom pad 111, a second bottom pad 121, and a third bottom pad 131 are provided on IC backplane 190 for connecting each bottom electrode (not shown) respectively. In some embodiments, bottom pads 111, 121, 131 are positive pads (P pads).

In some embodiments, first light emitting mesa 110 is provided at a bottom-most position. Second light emitting mesa 120 covers part of first light emitting mesa 110, and third light emitting mesa 130 covers part of second light emitting mesa 120. Referring to **FIG. 1** ,in this example, a shape of a top surface of first light emitting mesa 110 is a triangle, more specifically, a triangle with rounded corners. A shape of a top surface of second light emitting mesa 120 is an elongated strip and second light emitting mesa 120 is provided along one side of the triangle of first light emitting mesa 110. A shape of a top surface of third light emitting mesa 130 is a circle and third light emitting mesa 130 is provided above one end of second light emitting mesa 120. The top surface of first light emitting mesa 110 is lower than a bottom surface of second light emitting mesa 120, and the top surface of second light emitting mesa 120 is lower than a bottom surface of third light emitting mesa 130. That is, each light emitting mesa is spaced from, i.e., contact free from, the other light emitting mesas.

In some embodiments, the three or more light emitting mesas include at least a red light emitting mesa which emits red light, a green light emitting mesa which emits green light, and a blue light emitting mesa which emits blue light. For example, first light emitting mesa 110 is the red light emitting mesa, second light emitting mesa 120 is the green light emitting mesa, and third light emitting mesa 130 is the blue light emitting mesa. In some embodiments, first light emitting mesa 110 is the red light emitting mesa, second light emitting mesa 120 is the blue light emitting mesa, and third light emitting mesa 130 is the green light emitting mesa.

In some embodiments, a bottom conductive structure is provided at the bottom surface of each light emitting mesa to connect the light emitting mesa with a bottom pad. Referring to FIGs. 1 to 3, in this example, a first bottom conductive structure 114 of first light emitting mesa 110 is a bonding layer provided between first light emitting mesa 110 and IC backplane 190. First bottom conductive structure 114 can be connected to first bottom pad 111 directly. In some embodiments, a conductive film 116 is further provided between first bottom conductive structure 114 and first light emitting mesa 110. Conductive film 116 may provide an ohmic conduct on a positive side (P-side) of first light emitting mesa 110, and conductive film 116 together with the top surface of first bottom conductive structure 114 can form an ODR (omni-directional reflector) structure with high reflectivity. In some embodiments, conductive film 116 is a TCO (transparent conductive oxide) thin film, for example, an ITO (Indium Tin Oxide) film, an AZO (Antimony doped Zinc Oxide) film, an ATO (Antimony doped Tin Oxide) film, an FTO (Fluorine doped Tin Oxide) film, and the like. In some embodiments, a second bottom conductive structure 124 of second light emitting mesa 120 and a third bottom conductive structure 134 of third light emitting mesa 130 are conductive layers, which can be extended outside of the light emitting mesa.

In some embodiments, a bottom connecting structure is further provided to connect each of the bottom conductive structures to the corresponding bottom pads. Referring to FIGs. 1 to 3, in this example, a second bottom connecting structure 122 is provided beside second light emitting mesa 120 and is connected to a second bottom pad 121. Second bottom conductive structure 124 is extended and connected with second bottom connecting structure 122. Therefore, the bottom of second light emitting mesa 120 is connected to second bottom pad 121 through second bottom conductive structure 124 and second bottom connecting structure 122. A third bottom connecting structure 132 is provided beside third light emitting mesa 130 and is connected to a third bottom pad 131. Third bottom conductive structure 134 is extended and connected with third bottom connecting structure 132. Therefore, the bottom of third light emitting mesa 130 is connected to third bottom pad 131 through third bottom conductive structure 134 and third bottom connecting structure 132. In some embodiments, second bottom connecting structure 122 and third bottom connecting structure 132 are through vias, which are made of metal and with a hollow structure.

There is no limit to the shape of each of the bottom connecting structures. In some embodiments, the profile of the bottom connecting structures together with the light emitting mesas can be rectangular, which may be convenient for an arrangement of a micro LED panel.

In some embodiments, a top conductive structure is provided on a top surface of a light emitting mesa to connect the light emitting mesa with a top pad. Referring to **FIG. 2****,** in this example, a first top conductive structure 115 is provided on the top surface of first light emitting mesa 110. In some embodiments, first top conductive structure 115 is a first transparent conductive layer covering the whole top surface of first light emitting mesa 110. In some embodiments, first top conductive structure 115 of first light emitting mesa 110 is a first dot conductive structure formed on the top surface of first light emitting mesa 110. A dot conductive structure includes a plurality of conductive dots (or pads) formed on the top surface of light emitting mesa. In some embodiments, the first dot conductive structure is formed on a portion of the top surface of first light emitting mesa 110 where the top surface is not covered by second light emitting mesa 120. That is, the first dot conductive structure covers a part of the top surface of first light emitting mesa 110. Referring to **FIG. 3****,** a second top conductive structure 125 is provided on the top surface of second light emitting mesa 120. In some embodiments, second top conductive structure 125 is a second transparent conductive layer covering the whole top surface of second light emitting mesa 120. In some embodiments, second top conductive structure 125 is a second dot conductive structure formed on the top surface of second light emitting mesa 120. In some embodiments, the second dot conductive structure is formed on the top surface of second light emitting mesa 120 where the top surface is not covered by third light emitting mesa 130. That is, the second dot conductive structure covers a part of the top surface of second light emitting mesa 120.

Referring to **FIG. 2** and **FIG. 3****,** micro LED pixel 100 further includes a top conductive layer 160 formed on a top surface of micro LED pixel 100, and covering micro LED pixel 100. Top conductive layer 160 is configured to connect each light emitting mesa to a top electrode (not shown). In some embodiments, micro LED pixel 100 further includes a top connecting structure for connecting a light emitting mesa to top conductive layer 160. In this example, a first top connecting structure 113 is provided on first top conductive structure 115 of first light emitting mesa 110 and extends upward to a top of micro LED pixel 100 for connecting to top conductive layer 160. A second top connecting structure 123 is provided on second top conductive structure 125 of second light emitting mesa 120 and extends upward to the top of micro LED pixel 100 for connecting to top conductive layer 160. Top conductive layer 160 can connect to third light emitting mesa 130 directly. In some embodiments, top conductive layer 160 has a sunken portion 161 to be connected with third light emitting mesa 130. In some embodiments, first top connecting structure 113 and second bottom connecting structure 123 are through vias, which are made of metal and with a hollow structure. In some embodiments, top conductive layer 160 can be connected with a top electrode, for example, by an external wire.

In some embodiments, top conductive layer 160 is transparent with a light transmittance rate not less than 70%. In some embodiments, micro LED pixel 100 further includes a top pad 180 provided on a top surface of top conductive layer 160 and configured to provide a contact for connecting to the top electrode (not shown). In some embodiments, top pad 180 is provided at an edge of micro LED pixel 100 and around micro LED pixel 100. In some embodiments, top pad 180 is a negative pad (N pad). In some embodiments, the top electrode can be provided on IC backplane 190, and an external wire is further provided for connecting the top electrode with top pad 180.

Referring to FIGs. 1 to 3, optical isolation between adjacent micro LED pixels can be performed by second bottom connecting structure 122 and third bottom connecting structure 132. In some embodiments, to improve the optical isolation, micro LED pixel 100 further includes an optical isolation structure 140 provided at a corner corresponding to the triangle of first light emitting mesa 110, where third light emitting mesa 130 does not located on. In some embodiments, each of a gap G1 between second bottom connecting structure 122 and third bottom connecting structure 132 and a gap G2 between second bottom connecting structure 122 and optical isolation structure 140 between third bottom connecting structure 132 and optical isolation structure 140 is not greater than 1 micron, for example, each of G1 and G2 is equal or less than 0.1 micron. Therefore, the optical isolation can be further improved.

In some embodiments, optical isolation structure 140 is provided to extend between top conductive layer 160 and IC backplane 190. For example, a top of optical isolation structure 140 is equal to or higher than a top surface of third light emitting mesa 130, and a bottom of optical isolation structure 140 is equal to or lower than a bottom surface of first light emitting mesa 110. Optical isolation structure 140 does not connect with the light emitting mesas (including conductive structures and conductive film), top conductive layer 160, or IC backplane 190.

In some embodiments, optical isolation structure 140 is reflective. In some embodiments, a material of optical isolation structure 140 is metal.

Since second bottom connecting structure 122 and third bottom connecting structure 132 are connected with positive pads, second bottom connecting structure 122 and third bottom connecting structure 132 should be electrical isolated with each other. In some embodiments, gap G1 can also provide electrical isolation between second bottom connecting structure 122 and third bottom connecting structure 132.

Micro LED pixel 100 further includes a dielectric material filling a space within micro LED pixel 100, that is, the space between IC backplane 190 and top conductive layer 160. In some embodiments, the dielectric material fulfills the space among first light emitting mesa 110, second light emitting mesa 120, third light emitting mesa 130, second bottom connecting structure 122, third bottom connecting structure 132, IC backplane 190, top conductive layer 160, and optical isolation structure 140. In some embodiments, the dielectric material is selected from one or more of silicon oxide, silicon nitride, SiCN, SiNO, or Al₂O₃. In some embodiments, the dielectric material is transparent.

With the structure described above, the micro LED pixel provided by the embodiments of the present disclosure may have a good balance between high transmittance rate and dimension.

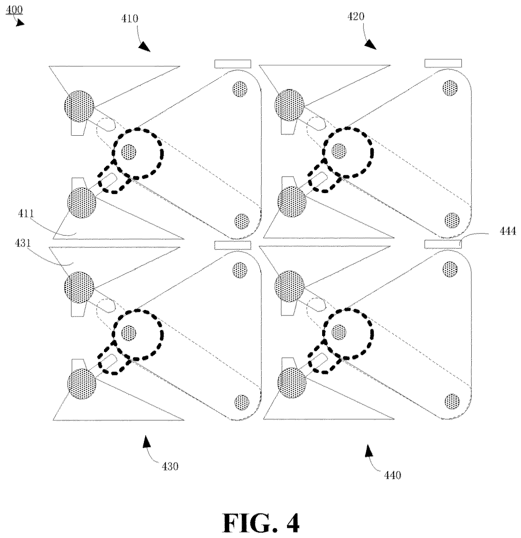

**FIG. 4** illustrates a structural diagram showing a top view of an example micro LED panel 400, according to some embodiments of the present disclosure. Micro LED panel 400 includes two or more micro LED pixels 100 arranged in array. As show in **FIG. 4****,** in this example, a 2×2 array is illustrated, where each micro LED pixel 410, 420, 430, and 440 can have with a rectangular shape. Therefore, the two or more micro LED pixels 100 can be arranged tightly. Most of the light crossing between two adjacent micro LED pixels 410 and 430 can be prevented by a bottom connecting structure 411 of micro LED pixel 410 and a bottom connecting structure 431 of micro LED pixel 430. An optical isolation structure 444 of micro LED pixel 440 is further provided between two adjacent micro LED pixels 420 and 440 to prevent light crossing.

Different types of micro LED panels can be provided. For example, the resolution of a display panel can range typically from 8×8 to 3840×2160. Common display resolutions include QVGA (Quarter Video Graphics Array) with 320×240 resolution and an aspect ratio of 4:3, XGA (Extended Graphics Array) with 1024×768 resolution and an aspect ratio of 4:3, D (Definition) with 1280×720 resolution and an aspect ratio of 16:9, FHD (Full High Definition) with 1920×1080 resolution and an aspect ratio of 16:9, UHD (Ultra High Definition) with 3840×2160 resolution and an aspect ratio of 16:9, and 4K with 4096×2160 resolution. There can also be a wide variety of pixel sizes, ranging from sub-micron and below to 10 mm and above. The size of the overall display region can also vary widely, ranging from diagonals as small as tens of microns or less up to hundreds of inches or more.

Micro LED panel 400 can be used as a micro LED display panel, a micro LED image panel, etc.

It is understood by those skilled in the art that, the micro LED panel is not limited by the structure disclosed above, and may include greater or fewer components than those as illustrated, or some components may be combined, or a different component may be utilized.

It should be noted that, the relational terms herein such as "first" and "second" are used only to differentiate an entity or operation from another entity or operation, and do not require or imply any actual relationship or sequence between these entities or operations. Moreover, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items.

As used herein, unless specifically stated otherwise, the term "or" encompasses all possible combinations, except where infeasible. For example, if it is stated that a database may include A or B, then, unless specifically stated otherwise or infeasible, the database may include A, or B, or A and B. As a second example, if it is stated that a database may include A, B, or C, then, unless specifically stated otherwise or infeasible, the database may include A, or B, or C, or A and B, or A and C, or B and C, or A and B and C.

In the foregoing specification, embodiments have been described with reference to numerous specific details that can vary from implementation to implementation. Certain adaptations and modifications of the described embodiments can be made. Other embodiments can be apparent to those skilled in the art from consideration of the specification and practice of the invention disclosed herein. It is intended that the specification and examples be considered as exemplary only, with a true scope and spirit of the invention being indicated by the following claims. It is also intended that the sequence of steps shown in figures are only for illustrative purposes and are not intended to be limited to any particular sequence of steps. As such, those skilled in the art can appreciate that these steps can be performed in a different order while implementing the same method.

In the drawings and specification, there have been disclosed exemplary embodiments. However, many variations and modifications can be made to these embodiments. Accordingly, although specific terms are employed, they are used in a generic and descriptive sense only and not for purposes of limitation.

## Claims

1. A micro LED pixel, comprising:
a first light emitting mesa;
a second light emitting mesa provided above the first light emitting mesa and covering a part of the first light emitting mesa; and
a third light emitting mesa provided above the second light emitting mesa and covering a part of the second light emitting mesa; wherein a shape of a top surface of the first light emitting mesa is a triangle.

2. The micro LED pixel according to claim 1, wherein a shape of a top surface of the second light emitting mesa is an elongated strip, and the second light emitting mesa is provided along a side of the triangle of the first light emitting mesa.

3. The micro LED pixel according to claim 2, wherein a shape of a top surface of the third light emitting mesa is a circle, and the third light emitting mesa is provided above an end of the second light emitting mesa.

4. The micro LED pixel according to claim 1, further comprising a plurality of bottom conductive structures configured to connect each of the first light emitting mesa, the second light emitting mesa, and the third light emitting mesa to an integrated circuit (IC) backplane, respectively.

5. The micro LED pixel according to claim 4, wherein a first one of the bottom conductive structures is a bonding layer provided between the first light emitting mesa and the IC backplane.

6. The micro LED pixel according to claim 5, wherein a second one of the bottom conductive structures is provided at a bottom of the second light emitting mesa, and the second bottom conductive structure is connected to the IC backplane by a first bottom connecting structure.

7. The micro LED pixel according to claim 6, wherein the first bottom connecting structure is a through via.

8. The micro LED pixel according to claim 6, wherein the second bottom conductive structure is a conductive layer.

9. The micro LED pixel according to claim 6, wherein a third one of the bottom conductive structures is provided at a bottom of the third light emitting mesa, and the third bottom conductive structure is connected to the IC backplane by a second bottom connecting structure.

10. The micro LED pixel according to claim 1, further comprising:
a top conductive layer provided on a top of the micro LED pixel;
a first top conductive structure configured to connect the first light emitting mesa to the top conductive layer; and
a second top conductive structure configured to connect the second light emitting mesa to the top conductive layer.

11. The micro LED pixel according to claim 10, wherein the first top conductive structure is a transparent conductive layer, and covers the top surface of the first light emitting mesa.

12. The micro LED pixel according to claim 10, wherein the first top conductive structure is a dot conductive structure.

13. The micro LED pixel according to claim 12, wherein the dot conductive structure is formed on a portion of the top surface of the first light emitting mesa where the surface is not covered by the second light emitting mesa.

14. The micro LED pixel according to claim 10, wherein the first top conductive structure is connected to the top conductive layer by a top connecting structure.

15. The micro LED pixel according to claim 10, wherein the second top conductive structure is a transparent conductive layer, and covers the top surface of the second light emitting mesa.

16. The micro LED pixel according to claim 15, wherein the second top conductive structure is a dot conductive structure.

17. The micro LED pixel according to claim 16, wherein the second top conductive structure is formed on a portion of a surface of the second light emitting mesa where the surface is not covered by the third light emitting mesa.

18. The micro LED pixel according to claim 10, wherein the second top conductive structure is connected to the top conductive layer by a top connecting structure.

19. The micro LED pixel according to claim 10, wherein the top conductive layer is directly connected to the third light emitting mesa.

20. The micro LED pixel according to claim 10, further comprising a top pad provided on a top surface of the top conductive layer.

21. The micro LED pixel according to claim 20, wherein the top pad is provided at an edge of the top conducive layer and around the micro LED pixel.

22. The micro LED pixel according to claim 10, further comprising a dielectric material filled between the top conductive layer and an integrated circuit (IC) backplane.

23. The micro LED pixel according to claim 1, further comprising an optical isolation structure provided at a corner of the micro LED pixel.

24. The micro LED pixel according to claim 1, wherein the first light emitting mesa is a red light emitting mesa.

25. The micro LED pixel according to claim 24, wherein the third light emitting mesa is a green light emitting mesa.

26. A micro LED panel comprising two or more micro LED pixels, wherein the at least one of the micro LED pixels comprises:
a first light emitting mesa;
a second light emitting mesa provided above the first light emitting mesa and covering a part of the first light emitting mesa; and
a third light emitting mesa provided above the second light emitting mesa and covering a part of the second light emitting mesa; wherein a shape of a top surface of the first light emitting mesa is a triangle.
